# EUROPÄISCHE PATENTANMELDUNG

(11) **EP 0 855 800 A1**
(43) Veröffentlichungstag der Anmeldung: **29.07.1998**
(21) Anmeldenummer: 98100106.8
(22) Anmeldetag: 07.01.1998
(51) Int. Cl.: H03K 17/95, B25B 5/12

(54) **Induktive Endstellungsabfrageeinrichtung**

(30) Priorität: 22.01.1997 DE 29700981 U
(71) Anmelder: DE-STA-CO Metallerzeugnisse GmbH, D-61449 Steinbach/Ts. (DE)
(72) Erfinder: Schauss, Peter, 65439 Flörsheim (DE)
(74) Vertreter: Wolf, Günter, Dipl.-Ing.

(57) **Zusammenfassung**

Die Erfindung betrifft eine induktive Endstellungsabfrageeinrichtung für Spannvorrichtungskopfstücke (K) mit einer von einem Linearstellglied (LS) betätigbaren Spannarmstellmechanik. Bei dieser weist das Linearstellglied (LS) einen Geber (G) für einen ersten und einen zweiten Nehmer(5,6) auf. Dabei sind die beiden Nehmer (5, 6) induktiv beeinflußbar ausgebildet in einem Gehäuse (1) angeordnet. Außerdem ist mindestens der zweite Nehmer (6) für die Öffnungsstellungsanzeige des Spannarmes verstellfixierbar ausgebildet. Nach der Erfindung ist im aus induktionsneutralem Material gebildeten Gehäuse (1) eine Nehmerelektronik (E) mit zu einem am Gehäuse (1) angeordneten Steckeranschluß (3) geführten Ausgangsleitungen (4, 4') angeordnet. Ferner ist von den zur Nehmerelektronik (E) gehörenden ersten und zweiten Nehmern (5, 6) mindestens der zweite Nehmer (6) für die Öffnungsstellungsanzeige, über eine elastische und im Gehäuse frei verbiegbare Leitung (7) mit der Nehmerelektronik (E) verbunden, verstell- und fixierbar in der geberseitigen Fläche (F) des Gehäuses (1) angeordnet.

## Beschreibung

Die vorliegende Erfindung betrifft eine induktive Endstellungsabfrageeinrichtung für Spannvorrichtungskopfstücke gemäß Oberbegriff des Hauptanspruches.

Derartige Endstellungsabfrageeinrichtungen sind bspw. nach FR-A-2 588 494 oder der EP-A-0 255 853 bekannt. Bei den dabei verwendeten induktiv beeinflußbaren Schaltern ist, soweit bekannt, in den Schaltern selbst die Schaltelektronik mit Nehmern mit enthalten. Außerdem ist zumindest der Schalter für die Öffnungsstellungsanzeige des Spannarmes verstellbar entweder direkt am Kopfstück der Spannvorrichtung, in einem am Kopfstück angesetzten Gehäuse oder am Fuß der Spannvorrichtung angeordnet. Da zur Einstellung des Öffnungswinkels der ganze Schalter versetzt werden muß, erfordert der ganze Versetzungsbereich relativ viel Raum, ganz abgesehen davon, daß entweder am Kopfstück oder am Gehäuse relativ aufwendige Versatz- und Befestigungsmittel vorgesehen sein müssen, die das Ganze auch nur bedingt handhabungsfreundlich machen. Außerdem müssen für jeden Schalter separate Kabelanschlüsse vorgesehen werden.

Ausgehend von einer Endstellungsabfrageeinrichtung der eingangs genannten Art, liegt der Erfindung die Aufgabe zugrunde, eine solche Endstellungsabfrageeinrichtung wesentlich einfacher, kompakter, handhabungsfreundlicher und letztlich auch fertigungsgünstiger zu gestalten.

Diese Aufgabe ist mit einer Endstellungsabfrageeinrichtung der eingangs genannten Art nach der Erfindung durch die im Kennzeichen des Patentanspruches 1 genannten Merkmale gelöst.

Durch diese Ausbildung werden Schalter mit ihrer Raumbeanspruchung entbehrlich. Außerdem ist die ganze Einrichtung, was noch näher erläutert wird, denkbar einfach und damit kostengünstig herstellbar, und auch die Verstellung des mindestens einen Schalters ist wesentlich vereinfacht, da nur noch der Nehmer als solcher im Bedarfsfall umgesetzt werden muß.

Vorteilhafte Weiterbildungen bestehen in Folgendem: Das Gehäuse ist aus einem blockartigen, mit einem ebenflächigen Deckel verschlossenen Unterteil gebildet, wobei das Unterteil Ausnehmungen einerseits für die Elektronik mit zugehörigen Leitungen und andererseits für mindestens den verstellbaren Nehmer zur Öffnungsstellungsanzeige aufweist. Diese Ausbildung macht das Gehäuse auch einer relativ einfachen Spritzgußfertigung zugänglich.

Die die Elektronik mit ihren zugehörigen Leitungen enthaltende Ausnehmung ist mit einer induktionsneutralen Vergußmasse ausgefüllt. Dadurch ist die Elektronik mit zugehörigen Leitungen absolut sicher eingebettet im blockartigen Unterteil untergebracht.

Ferner ist am Gehäuse längs eines Nehmerverstellbereiches eine Rastleiste zur wählbaren Positionierung eines an der Rastleiste klemmfixierbaren Nehmergehäuses angeordnet, wobei am auf das Gehäuse aufsetzbaren Deckel, fluchtend zur Rastleiste und sich über deren Länge erstreckend, ein Gegenklemmelement, wie Elastikpolsterstreifen oder entsprechend ausgebildete Rastleiste, angeordnet. Bei abgenommenem Deckel ist also der umsetzbare Nehmer direkt zugänglich und braucht nur noch in die gewünschte Position umgesetzt zu werden, wonach der Deckel einfach wieder aufgesetzt bzw. geschlossen wird.

Bevorzugt wird eine Ausführungsform dahingehend, daß das blockartige Gehäuseunterteil und der Deckel in Form eines Kunststoffspritzgußteiles ausgebildet sind, wobei der Deckel längs einer Biegelinie mit dem Gehäuseunterteil verbunden und außerdem mit dem Gehäuseunterteil schnappverrastbar ausgebildet ist.

Die erfindungsgemäße Endstellungsabfrageeinrichtung und zusätzliche vorteilhafte Weiterbildungen werden nachfolgend anhand der zeichnerischen Darstellung von Ausführungsbeispielen näher erläutert.

Es zeigt
- Fig. 1: in Seitenansicht die Endstellungsabfrageeinrichtung;
- Fig. 2: die Abfrageeinrichtung gemäß Fig. 1 von links aus gesehen;
- Fig. 3: teilweise im Schnitt und in Seitenansicht das Gehäuse bei abgenommenem Deckel;
- Fig. 4: teilweise im Schnitt und Ansicht das Gehäuse von der Geberseite aus gesehen;
- Fig. 5: eine Darstellung gemäß Fig.3 mit Linearstellglied einer ansonsten nicht dargestellten Spannvorrichtung, Geber und den elektrischen Komponenten;
- Fig. 6: stark vergrößert den verstellbaren Sensor und
- Fig. 7: eine Darstellung gemäß Fig. 4 mit einer anderen Ausführungsform des Deckels.

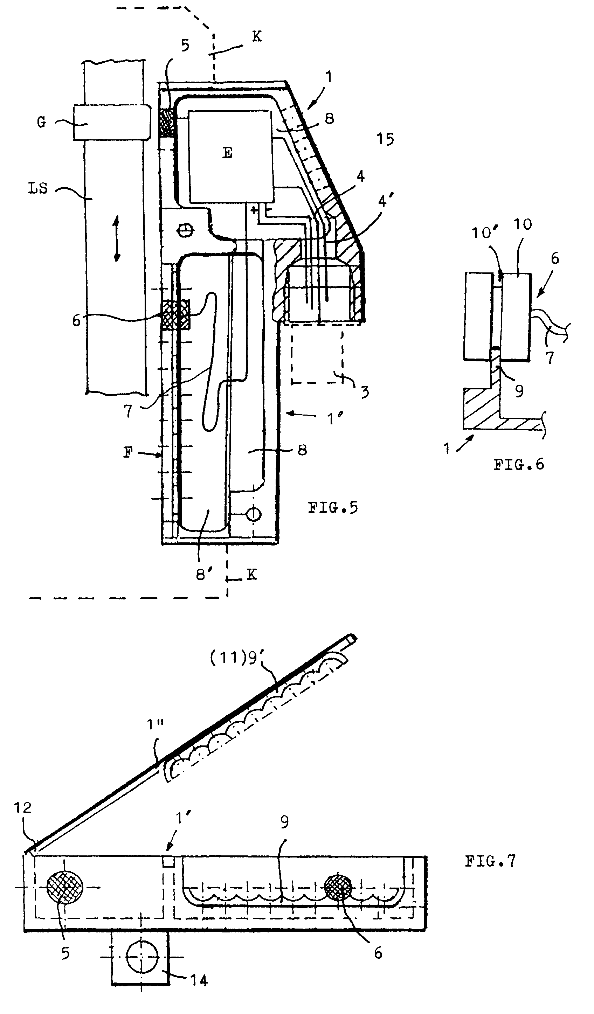

Ausgegangen ist in bekannter Weise von einer induktiven Endstellungsabfrageeinrichtung für Spannvorrichtungskopfstücke K (nur gestrichelt in Fig. 5 angedeutet) mit einer von einem Linearstellglied LS betätigbaren Spannarmstellmechanik (nicht dargestellt), bei der das Linearstellglied LS einen Geber G für einen ersten und einen zweiten Nehmer 5,6 aufweist, wobei die beiden Nehmer 5, 6 induktiv beeinflußbar ausgebildet in einem Gehäuse angeordnet sind und mindestens der zweite Nehmer 6 für die Öffnungsstellungsanzeige des Spannarmes verstellfixierbar ausgebildet ist.

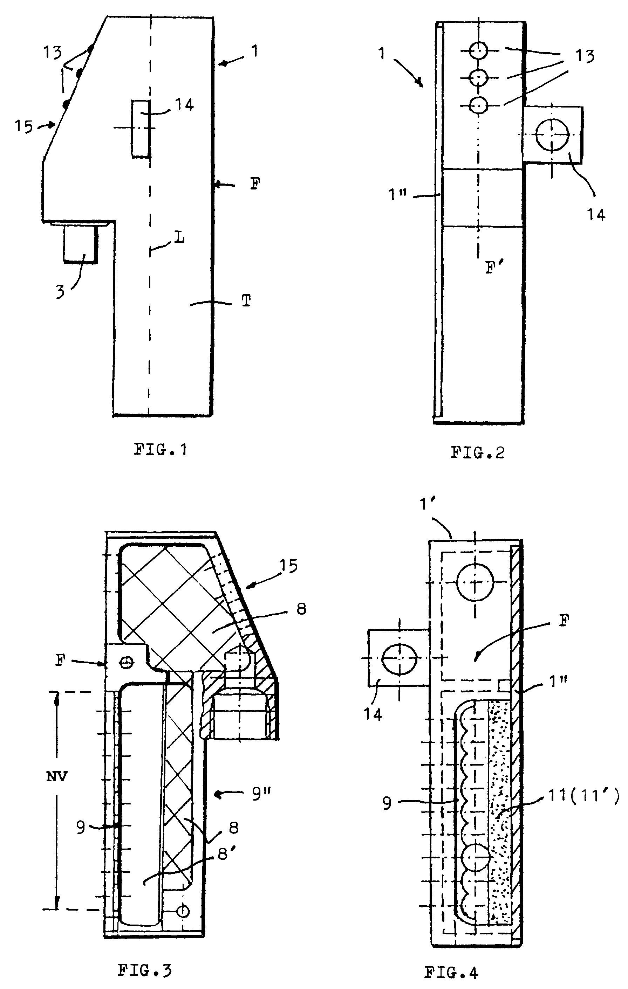

Vorab sei darauf hingewiesen, daß die Abfrageeinrichtung in der dargestellten Ausführungsform mit dem rechts neben der gestrichelten Linie L in Fig. 1 befindlichen Teil T bei einem gabelförmigen Kopfstück in den Spalt des Kopfstückes K eingreift oder, wenn es sich um ein geschlossenes Kopfstück K handelt, in eine entsprechende Durchgriffsöffnung auf der Rückseite des Kopfstückes.

Für die auf diese Weise an Kopfstücken von Spannvorrichtungen an- bzw. einsetzbaren Abfrageeinrichtungen ist nun unter Verweis auf insbesondere Fig. 5 wesentlich, daß im aus induktionsneutralem Material gebildeten Gehäuse 1 eine Nehmerelektronik E mit zu einem am Gehäuse 1 angeordneten Steckeranschluß 3 geführten Ausgangsleitungen 4, 4' angeordnet ist, und daß von den zur Nehmerelektronik E gehörenden ersten und zweiten Nehmern 5, 6 mindestens der zweite Nehmer 6 für die Öffnungsstellungsanzeige, über eine elastische und im Gehäuse frei verbiegbare Leitung 7 mit der Nehmerelektronik E verbunden, verstell- und fixierbar in der geberseitigen Fläche F des Gehäuses 1 angeordnet ist.

Statt bisher üblicher, induktiver Schalter ist hier im oberen Teil des Gehäuses 1 eine Nehmerelektronik E stationär angeordnet, die mit den beiden Nehmern 5, 6 in Verbindung steht, wobei hier der zweite Nehmer 6 für die Öffnungsstellungsanzeige des Spannarmes (nicht dargestellt) der Spannvorrichtung verstellt bzw. positioniert wird, je nachdem in welche Öffnungsstellung der Spannarm zurückgeschlagen werden soll.

Das Gehäuse 1 ist aus einem blockartigen, mit einem ebenflächigen Deckel 1'' verschlossenen Unterteil 1' gebildet, wobei das Unterteil 1' Ausnehmungen 8, 8' einerseits für die Elektronik E mit zugehörigen Leitungen und andererseits für mindestens den verstellbaren zweiten Nehmer 6 zur Öffnungsstellungsanzeige aufweist (siehe Fig. 4). Die Ausnehmung 8 (siehe grobe Kreuzschraffur in Fig. 3) mit der darin untergebrachten Elektronik und den zugehörigen Leitungen ist mit einer induktivneutralen Vergußmasse ausgefüllt.

Neben der von Vergußmasse freibleibende Ausnehmung 8' (siehe Fig. 3 und 5) ist am Gehäuse 1 längs des Nehmerverstellbereiches NV eine Rastleiste 9 zur wählbaren Positionierung eines an der Rastleiste 9 klemmfixierbaren Nehmergehäuses 10 angeordnet, wobei am auf das Gehäuse 1 aufsetzbaren Deckel l'', fluchtend zur Rastleiste 9 und sich über deren Länge erstreckend, ein Gegenklemmelement 11, wie Elastikpolsterstreifen 11' (Fig. 4) oder entsprechend ausgebildete Rastleiste 9' (Fig. 7) angeordnet ist.

Bei entfertem Deckel l" liegt dabei der zweite Nehmer 6 für eine Umpositionierung frei, der vorteilhaft im Sinne der Fig. 6 ausgebildet ist, d.h., als kleiner zylindrischer Körper mit einer umlaufenden Nut 10', mit der das Nehmergehäuse 10 auf die wie dargestellt ausgebildete Rastleiste 9 klemmend aufgesteckt wird. Beim Wiederaufsetzen des Deckels l" wird dabei automatisch das Nehmergehäuse 10 in seiner Position an der Rastleiste 9 festgelegt.

Mit Rücksicht auf einen günstigen Kabelanschluß weist das Gehäuse 1 ein in bezug auf den Rastleistenteil 9" breiteres Kopfteil 15 mit der Ausnehmung 8 für die Elektronik E auf, und an der Überstandsfläche F' des Kopfteiles 15 ist der Steckanschluß für die Elektronik E angeordnet.

Vorteilhaft und bevorzugt sind das blockartige Gehäuseunterteil l' und der Deckel l" in Form eines Kunststoffspritzgußteiles ausgebildet, wobei der Deckel l", längs einer Biegelinie 12 mit dem Gehäuseunterteil l' verbunden und außerdem mit dem Gehäuseunterteil l' schnappverrastbar ausgebildet ist. Hierzu wird auf Fig. 7 verwiesen, in der allerdings Elemente zur Schnappverrastung nicht dargestellt sind, zumal es dafür die unterschiedlichsten Ausführungsmöglichkeiten gibt. Die Anlenkung des Deckels l", wie dargestellt, ist übrigens nicht zwingend, zumal diese letztlich von der Gestaltung und Form des Gehäuseunterteiles l' abhängig ist.

Durch den Wegfall separat verstellbarer Induktivschalter und die konzentrierte Unterbringung der Gesamtelektronik E für beide Nehmer 5, 6 im oberen Gehäuseteil kann vorteilhaft die Anordnung von Leuchtdioden 13 am Kopfteil 15, wie in Fig. 1, 2 dargestellt, vorgesehen werden, die zum einen den Betriebszustand der Abfrageeinrichtung anzeigen (mittige Diode), und zum anderen die Schließ- oder Öffnungsstellung des Spannarmes der Spannvorrichtung. Eine Lasche 14 am Gehäuse 1 dient zur Befestigung am Kopfstück K der Spannvorrichtung.

Falls auch erwünscht ist, Nehmereinstellungen für die Spann- bzw. Schließstellung vornehmen zu können (Unter-, Tot- und Übertotpunktstellung), so ist es ohne weiteres möglich, den diesbezüglichen ersten Nehmer 5 wie den zweiten Nehmer 6 auszubilden und die Rastleiste 9 entsprechend zu verlängern bzw. im Anordnungsbereich des ersten Nehmers 5 eine weitere entsprechend feingerasterte Rastleiste anzuordnen, was nicht besonders dargestellt ist, da ohne weiteres vorstellbar.

## Patentansprüche

1. Induktive Endstellungsabfrageeinrichtung für Spannvorrichtungskopfstücke (K) mit einer von einem Linearstellglied (LS) betätigbaren Spannarmstellmechanik, bei der das Linearstellglied (LS) einen Geber (G) für einen ersten und einen Zweiten Nehmer(5,6) aufweist, wobei die beiden Nehmer (5,6) induktiv beeinflußbar ausgebildet in einem Gehäuse (1) angeordnet sind und mindestens der zweite Nehmer (6) für die Öffnungsstellungsanzeige des Spannarmes verstellfixierbar ausgebildet ist,
**dadurch gekennzeichnet,**
daß im aus induktionsneutralem Material gebildeten Gehäuse (1) eine Nehmerelektronik (E) mit zu einem am Gehäuse (1) angeordneten Steckeranschluß (3) geführten Ausgangsleitungen (4, 4') angeordnet ist, und daß von den zur Nehmerelektronik (E) gehörenden ersten und zweiten Nehmern (5, 6) mindestens der zweite Nehmer (6) für die Öffnungsstellungsanzeige, über eine elastische und im Gehäuse frei verbiegbare Leitung (7) mit der Nehmerelektronik (E) verbunden, verstell- und fixierbar in der geberseitigen Fläche (F) des Gehäuses (1) angeordnet ist.

2. Abfrageeinrichtung nach Anspruch 1,
**dadurch gekennzeichnet,**
daß das Gehäuse (1) aus einem blockartigen, mit einem ebenflächigen Deckel (1'') verschlossenen Unterteil (1') gebildet ist, wobei das Unterteil (1') Ausnehmungen (8, 8') einerseits für die Elektronik (E) mit zugehörigen Leitungen und andererseits für mindestens den verstellbaren Nehmer (6) zur Öffnungsstellungsanzeige aufweist.

3. Abfrageeinrichtung nach Anspruch 1 oder 2,
**dadurch gekennzeichnet,**
daß die die Elektronik (E) mit ihren zugehörigen Leitungen enthaltende Ausnehmung (8) mit einer induktionsneutralen Vergußmasse ausgefüllt ist.

4. Abfrageeinrichtung nach einem der Ansprüche 1 bis 3,
**dadurch gekennzeichnet,**
daß am Gehäuse (1) längs eines Nehmerverstellbereiches (NV) eine Rastleiste (9) angeordnet ist zur wählbaren Positionierung eines an der Rastleiste (9) klemmfixierbaren Nehmergehäuses (10), wobei am auf das Gehäuse (1) aufsetzbaren Deckel (l'') fluchtend zur Rastleiste (9) und sich über deren Länge erstreckend, ein Gegenklemmelement (11), wie Elastikpolsterstreifen(11') oder entsprechend ausgebildete Rastleiste (9) angeordnet ist.

5. Abfrageeinrichtung nach einem der Ansprüche 1 bis 4,
**dadurch gekennzeichnet,**
daß das Gehäuse (1) ein in bezug auf den Rasterleistenteil (9") breiteres Kopfteil (15) mit der Ausnehmung (8) für die Elektronik (E) aufweist und daß an der Überstandsfläche (F') des Kopfteiles (15) der Steckanschluß (3) für die Elektronik (E) angeordnet ist.

6. Abfrageeinrichtung nach einem der Ansprüche 2 bis 5,
**dadurch gekennzeichnet,**
daß das blockartige Gehäuseunterteil (1') und der Deckel (l") in Form eines Kunststoffspritzgußteiles ausgebildet sind, wobei der Deckel (l") längs einer Biegelinie (12) mit dem Gehäuseunterteil (1') verbunden und außerdem mit dem Gehäuseunterteil (1') schnappverrastbar ausgebildet ist.

7. Abfrageeinrichtung nach einem der Ansprüche 1 bis 6,
**dadurch gekennzeichnet,**
daß anschlußseitig am oberen Teil des Gehäuses (1) drei Leuchtdioden (13) angeordnet sind.

8. Abfrageeinrichtung nach einem der Ansprüche 1 bis 7,
**dadurch gekennzeichnet,**
daß der erste Nehmer (5) bei gleicher Ausbildung wie der zweite Nehmer (6) und bei verlängerter oder zusätzlicher Rasterleiste (9) ebenfalls verstellbar ausgebildet ist.
